# EUROPÄISCHE PATENTANMELDUNG

(11) **EP 0 834 988 A2**
(43) Veröffentlichungstag der Anmeldung: **08.04.1998**
(21) Anmeldenummer: 97114178.3
(22) Anmeldetag: 18.08.1997
(51) Int. Cl.: H03G 3/30

(54) **Verfahren zur automatischen Begrenzung von Verzerrungen an Audio-Geräten und Schaltungsanordnung zur Durchführung des Verfahrens**

(30) Priorität: 28.09.1996 DE 19640132
(71) Anmelder: Volkswagen Aktiengesellschaft, 38436 Wolfsburg (DE)
(72) Erfinder: Beyer, Detlev, 38550 Isenbüttel (DE)

(57) **Zusammenfassung**

Die Erfindung betrifft ein Verfahren zur automatischen Begrenzung von Verzerrungen an Audio-Geräten mittels eines Verzerrungsdetektors (3) zur Ermittlung eines Klirrfaktors, dessen Ausgang an einen Verstärkungsregelungseingang (6) des Audio-Gerätes zurückgekoppelt ist, wobei der Verzerrungsdetektor (3) den Klirrfaktor des Ausgangssignales des Audio-Gerätes (2) frequenzabhängig ermittelt und bei Überschreitung eines frequenzabhängigen, einstellbaren Schwellenwertes des Klirrfaktors ein Steuersignal erzeugt, daß die Verstärkung des Audio-Gerätes (2) herunterregelt.

## Beschreibung

Die Erfindung betrifft ein Verfahren zur automatischen Begrenzung von Verzerrungen an Audio-Geräten und eine Schaltungsanordnung zur Durchführung des Verfahrens.

Wegen der starken Nichtlinearität der Übertragungskennlinie von Verstärkern treten Verzerrungen auf, wenn die Amplitude eines Eingangssignales nicht verschwindend klein ist. Ein Maß für die Verzerrungen ist der Klirrfaktor. Der Klirrfaktor gibt das Effektivwert-Verhältnis der Oberschwingungen zur Grundschwingung am Ausgang an.

Insbesondere in Autoradios wird häufig die Lautstärke derart hoch eingestellt, daß die Endstufen übersteuert werden und somit ein hoher Klirrfaktor entsteht. Diese kann beispielsweise auch auftreten, wenn von einem Sender mit relativ niedrigen Frequenzhub auf einen Sender mit hohem Frequenzhub umgeschaltet wird, nachdem zuvor die Lautstärke noch auf einen bezüglich des Klirrfaktors annehmbaren Wert eingestellt war. Zur Vermeidung eines zu großen Klirrfaktors wird daher ein fester Schwellenwert zwischen 0,2 - 20 % Klirrfaktor eingestellt, bei dessen Überschreitung die Verstärkung des Audio-Gerätes reduziert wird, bis der Grenzwert des Klirrfaktors wieder unterschritten wird.

Eine solche Vorrichtung ist z.B. aus der DE 43 40 167 bekannt, bei der an der Endstufe des Audio-Gerätes ein Signal abnehmbar ist, das einen vorgegebenen Aussteuerungsgrad kennzeichnet, das über ein Integrationsglied geleitete Signal eine den Klirrfaktor beschreibende Spannung bildet und über eine vorgegebene Kennlinie eine Stellgröße bildet, die einem Stellglied für die Verstärkung der Audiosignale zugeleitet wird. Nachteilig an der bekannten Vorrichtung ist, daß bei auftretenden Baßimpulsen der Klirrfaktor überschritten wird und das Audiosignal über seinen gesamten Frequenzbereich in der Ausgangsleistung reduziert wird. Dadurch kommt es zum sogenannten "breathing", d.h. die hörbare Gesamtlautstärke des Audiosignals variiert im Rhythmus der auftretenden Baßimpulse.

Aus der US 5,255,324 ist eine Vorrichtung zur Anpassung der Verzerrung an Audio-Geräten bekannt, bei der zur Vermeidung von "breathing" der Baßbereich selektiv beobacht- und steuerbar ausgebildet ist. Das Prinzip läßt sich anhand der Fig. 2 der Druckschrift näher erläutern. Es wird ein fester, frequenzunabhängiger Grenzwert für den Klirrfaktor definiert. Überschreitet das Ausgangssignal des Audio-Gerätes bei irgendeiner Signalfrequenz den Grenzwert des Klirrfaktors, so wird zunächst überprüft, ob der Grenzwert des Klirrfaktors im Baßbereich überschritten wurde. Trifft dies zu, so wird nur die Baßverstärkung reduziert und erneut überprüft, ob das Ausgangssignal über dem Grenzwert liegt. Trifft dies zu, so wird geprüft, ob der Grenzwert des Baßbereiches immer noch überschritten wird. Erst wenn der Grenzwert des Baßbereiches nicht mehr überschritten wird und trotzdem das Ausgangssignal den Grenzwert den Klirrfaktors noch überschreitet, wird die Verstärkung des gesamten Frequenzbereiches reduziert. Nachteilig an der bekannten Vorrichtung ist die aufwendige und langsame Regelung.

Der Erfindung liegt daher das technische Problem zugrunde, ein einfacheres Verfahren zur automatischen Anpassung von Verzerrungen an Audio-Geräten und eine Schaltungsanordnung zur Durchführung des Verfahrens zu schaffen.

Die Lösung des Problems ergibt sich durch die Merkmale der Patentansprüche 1, 2 und 7. Durch die frequenzabhängige Ermittlung des Klirrfaktors des Ausgangssignals und der frequenzabhängigen Einstellung des Schwellenwertes des Klirrfaktors kann ohne aufwendige Regelung eine Anpassung von Verzerrungen am Audio-Gerät vorgenommen werden. Durch die frequenzabhängige Einstellung des Schwellenwertes des Klirrfaktors ist es darüber hinaus möglich, sehr einfach das Verfahren an individuelle Hörbedürfnisse des Benutzers, die zu hörende Musik und/oder die Umgebung des Audio-Gerätes anzupassen. Bei dem Verfahren nach Patentanspruch 2 wird zusätzlich dafür Sorge getragen, daß das Audio-Gerät immer mit maximal zulässiger Verstärkung betrieben wird. Dazu wird die Verstärkung beim Unterschreiten des Schwellenwertes des Klirrfaktors wieder automatisch erhöht, bis erneut der Schwellenwert des Klirrfaktors überschritten wird. Weitere vorteilhafte Ausgestaltungen der Erfindung ergeben sich aus den Unteransprüchen. Durch die jeweils konstante Definition des Schwellenwertes des Klirrfaktors in einzelnen Frequenzabschnitten kann das Verfahren mit kostengünstigen Digitalbauteilen bei der Überprüfung des Schwellenwertes des Klirrfaktors durchgeführt werden. Da das menschliche Gehör Impulsverzerrungen im Baßbereich (<400 Hz) nicht so deutlich wahrnehmen kann, ist es für die Gesamtakustik vorteilhaft, den Schwellenwert des Klirrfaktors im Baßbereich größer als im oberen Frequenzbereich (>400 Hz) zu wählen. In einer weiteren Ausführungsform wird der Schwellenwert des Klirrfaktors im Baßbereich für sehr tiefe Frequenzen mit einem großen Schwellenwert konstant und zu höheren Frequenzen hin linear oder parabolisch abnehmend definiert. Außerhalb des Baßbereiches wird dann der Schwellenwert des Klirrfaktors wieder konstant auf niedrigem Niveau definiert. Dadurch wird eine nahezu optimale Anpassung an das akustische Wahrnehmungsvermögen von Verzerrungen eines Menschen erreicht. Die Erfindung findet bevorzugt Anwendung für Audio-Geräte in Kraftfahrzeugen.

Die Erfindung wird nachfolgend anhand eines bevorzugten Ausführungsbeispieles näher erläutert. Die Figuren zeigen:

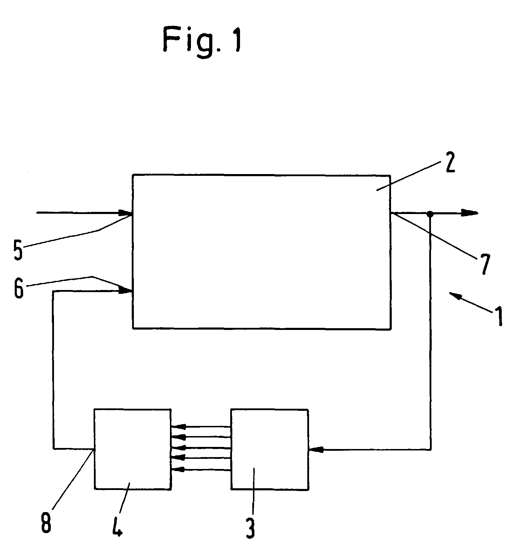

- Fig. 1:: ein schematisches Blockschaltbild einer Schaltung zur Durchführung des Verfahrens und
- Fig. 2:: eine Funktion des Schwellenwertes des Klirrfaktors über der Frequenz.

Die Schaltungsanordnung 1 umfaßt ein Audio-Gerät 2, einen frequenzselektiven Verzerrungsdetektor 3 und einen Komparator 4. Das Audio-Gerät 2 umfaßt einen Signaleingang 5, einen verstellbare Eingangsverstärkungsregelung 6 und einen Signalausgang 7. Der Signalausgang 7 ist mit einem Eingang des frequenzselektiven Verzerrungsdetektor 3 verbunden, dessen Ausgänge mit den Eingängen des Komparators 4 verbunden sind. Ein Ausgang 8 des Komparators 4 ist mit der Eingangsverstärkungsregelung 6 verbunden.

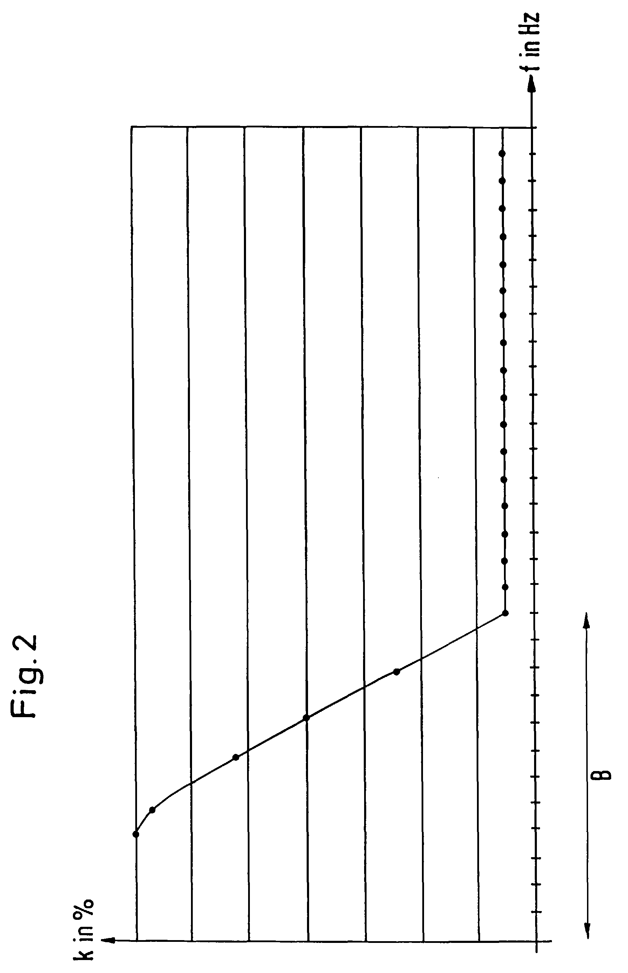

Das Audio-Gerät 2 erhält über seinen Signaleingang 5 ein Audio-Signal. Dieses Audio-Signal kann z.B. ein frequenzmoduliertes Radiosignal von einer Antenne sein. Da aber der Vorgang der Demodulation für die vorliegende Erfindung nicht wesentlich ist, wird der Einfachheit halber angenommen, es handele sich bereits um das niederfrequente Audio-Signal. Das Audio-Signal wird entsprechend der eingestellten Verstärkung der Eingangsverstärkungsregelung verstärkt und über den Signalausgang 7 an nicht dargestellte Lautsprecher oder Booster abgegeben. Aus dem am Signalausgang 7 anliegenden Ausgangssignal ermittelt der Verzerrungsdetektor 3 frequenzselektiv die einzelnen Klirrfaktoren für jede Frequenz des Ausgangssignals. Die ermittelten Werte für die jeweiligen Klirrfaktoren werden an die Eingänge eines Komparators 4 weitergegeben, wo diese mit für jede einzelne Frequenz vorgegebene Schwellenwerte des Klirrfaktors verglichen werden. Eine solche frequenzabhängige Vorgabe des Schwellenwertes für den Klirrfaktor ist z.B. in Fig. 2 dargestellt, dabei ist mit B der Bassbereich gekennzeichnet. Ergibt der Vergleich der aktuellen Werte der Klirrfaktoren des Ausgangssignals mit den Schwellenwerten des Klirrfaktors keine Überschreitung des Schwellenwertes bei einer Frequenz, so wird die eingestellte Verstärkung beibehalten bzw. bei Bedarf herauf geregelt. Wird der Schwellenwert des Klirrfaktors für irgendeine Frequenz überschritten, so erzeugt der Komparator 4 eine Stellgröße, die die Verstärkung solange herunterregelt, bis der Schwellenwert des Klirrfaktors nicht mehr überschritten wird. Die Verknüpfung der einzelnen Ausgangssignale im Komparator 4, ob der Schwellenwert für eine einzelne Frequenz überschritten wurde, erfolgt z.B. über eine bekannte Oder-Vernüpfung. Vorzugsweise sind der frequenzselektive Verzerrungsdetektor 3 und der Komparator 4 in das Audio-Gerät 2 integriert.

### BEZUGSZEICHENLISTE

- 1: Schaltungsanordnung
- 2: Audio-Gerät
- 3: Verzerrungsdetektor
- 4: Komparator
- 5: Signaleingang
- 6: Eingangsverstärkungsregelung
- 7: Signalausgang
- 8: Ausgang
- B: Bassbereich

## Patentansprüche

1. Verfahren zur automatischen Begrenzung von Verzerrungen an Audio-Geräten mittels eines Verzerrungsdetektors zur Ermittlung eines Klirrfaktors, dessen Ausgang an einen Verstärkungsregelungseingang des Audio-Gerätes zurückgekoppelt ist,
**dadurch gekennzeichnet, daß**
der Verzerrungsdetektor (3) den Klirrfaktor des Ausgangssignales des Audio-Gerätes (2) frequenzabhängig ermittelt und bei Überschreitung eines frequenzabhängigen, einstellbaren Schwellenwertes des Klirrfaktors ein Steuersignal erzeugt, daß die Verstärkung des Audio-Gerätes (2) herunterregelt.

2. Verfahren zur automatischen Begrenzung von Verzerrungen an Audio-Geräten mittels eines Verzerrungsdetektors zur Ermittlung eines Klirrfaktors, dessen Ausgang an einen Verstärkungsregelungseingang des Audio-Gerätes zurückgekoppelt ist,
**dadurch gekennzeichnet, daß**
der Verzerrungsdetektor (3) die Verzerrung des Ausgangssignals des Audio-Gerätes (2) frequenzabhängig ermittelt und die Verstärkung des Audio-Gerätes (2) bis zum Erreichen des frequenzabhängigen Schwellenwertes des Klirrfaktors nachregelt.

3. Verfahren nach Anspruch 1 oder 2, dadurch gekennzeichnet, daß der Schwellenwert des Klirrfaktors in Frequenzabschnitten jeweils konstant definiert wird.

4. Verfahren nach einem der vorhergehenden Ansprüche, dadurch gekennzeichnet, daß der Schwellenwert des Klirrfaktors im unteren Frequenzbereich, insbesondere im Baßbereich, größer als im oberen Frequenzbereich gewählt wird.

5. Verfahren nach Anspruch 1 oder 2, dadurch gekennzeichnet, daß der Schwellenwert des Klirrfaktors im unteren Frequenzbereich konstant definiert wird, in einem anschließenden mittleren Frequenzbereich annähernd linear oder parabolisch zur höheren Frequenzen hin abnimmt und im anschließenden oberen Frequenzbereich wieder konstant definiert ist, wobei der Schwellenwert des Klirrfaktors im unteren Frequenzbereich größer als im oberen Frequenzbereich gewählt wird.

6. Verfahren nach Anspruch 5, dadurch gekennzeichnet, daß der untere und der mittlere Frequenzbereich den Baßbereich bilden.

7. Schaltungsanordnung zur Durchführung des Verfahrens nach einem der vorhergehenden Ansprüche, umfassend ein Audio-Gerät und einen Verzerrungsdetektor am Ausgang des Audio-Gerätes, der auf einen Verstärkungsregelungseingang des Audio-Gerätes zurückgekoppelt ist, dadurch gekennzeichnet, daß der Verzerrungsdetektor (3) frequenzselektiv ist und im Rückkopplungszweig einzelnen Frequenzbereichen zugeordnete Komparatoren (4) angeordnet sind, die voneinander unabhängige Schwellenwerte für den Klirrfaktor aufweisen.

8. Schaltungsanordnung nach Anspruch 7, dadurch gekennzeichnet, daß die Schaltungsanordnung für ein Audio-Gerät in einem Kraftfahrzeug verwendet wird.
